# EUROPEAN PATENT APPLICATION

(11) **EP 4 296 605 A1**
(43) Date of publication of application: **27.12.2023**
(21) Application number: 23178953.8
(22) Date of filing: 13.06.2023
(51) Int. Cl.: F41H 13/00, H05K 7/14, H05K 7/20

(54) **SUPERCOOLED THERMAL STORAGE FOR HIGH LOAD SHORT DURATION COOLING**

(30) Priority: 13.06.2022 US 202217838695
(71) Applicant: Hamilton Sundstrand Corporation, Charlotte, NC 28217-4578 (US)
(72) Inventor: VIGNALI, Mark, Simsbury, CT, 06070 (US)
(74) Representative: Dehns

(57) **Abstract**

A thermal management system for a directed energy weapon (22) includes a heat exchanger (24) thermally coupled to the directed energy weapon. The heat exchanger has a heat exchanger inlet (36) and a heat exchanger outlet (28). A storage reservoir (26) contains a thermal material. An outlet (34) of the storage reservoir is arranged in fluid communication with the heat exchanger to form a closed loop having a thermal management fluid circulating therethrough. The storage reservoir is thermally coupled to a secondary system (40). A control valve (50) is positioned downstream from the outlet of the storage reservoir. The control valve is adjustable to control a temperature of the thermal management fluid provided to the heat exchanger.

## Description

### BACKGROUND

Exemplary embodiments of the present disclosure relate to the art of a thermal management system, and more specifically, to a thermal management system for removing heat from a directed energy weapon (DEW).

Vehicles, such as aircraft, are being designed with advanced weapons like laser based direct energy weapons (DEWs). DEWs (e.g., laser weapons) may require substantial cooling at the lowest possible weight for sustained operation. DEWs typically operate at low efficiency and thus, generate a large amount of heat during operation, such as when the weapon is firing. DEW operation typically consists of relatively brief operating intervals, wherein relatively large "bursts" of cooling are required, interspersed with relatively long intervals in which the weapon is quiescent, and therefore, requires little or no cooling. This large thermal transient may drive the size of the thermal management system used to control the thermal loading of the DEW. Such requirements may result in a thermal management system that is significantly oversized, inefficient and heavy for normal operating (non-lasing) modes. Therefore, a fast and efficient thermal management system is desired to address the thermal load of a DEW and to protect onboard components from thermal transients.

### BRIEF DESCRIPTION

According to an embodiment, a thermal management system for a directed energy weapon includes a heat exchanger thermally coupled to the directed energy weapon. The heat exchanger has a heat exchanger inlet and a heat exchanger outlet. A storage reservoir contains a thermal material. An outlet of the storage reservoir is arranged in fluid communication with the heat exchanger to form a closed loop having a thermal management fluid circulating therethrough. The storage reservoir is thermally coupled to a secondary system. A control valve is positioned downstream from the outlet of the storage reservoir. The control valve is adjustable to control a temperature of the thermal management fluid provided to the heat exchanger.

In addition to one or more of the features described above, or as an alternative to any of the foregoing embodiments the secondary system further comprises a cooling coil thermally coupled to the storage reservoir.

In addition to one or more of the features described above, or as an alternative to any of the foregoing embodiments the cooling coil is mounted within an interior of the storage reservoir.

In addition to one or more of the features described above, or as an alternative to any of the foregoing embodiments comprising a bypass conduit extending from a position between the heat exchanger outlet and an inlet of the storage reservoir. The bypass conduit is configured to bypass the storage reservoir and the control valve.

In addition to one or more of the features described above, or as an alternative to any of the foregoing embodiments a first portion of the thermal management fluid at the heat exchanger outlet is provided to the bypass conduit and a second portion of the thermal management fluid at the heat exchanger outlet is provided to the storage reservoir. The first portion of the thermal management fluid and the second portion of the thermal management fluid are mixed at a location upstream from the heat exchanger inlet.

In addition to one or more of the features described above, or as an alternative to any of the foregoing embodiments the control valve is operable to control the temperature of the thermal management fluid provided to the heat exchanger by controlling an amount of the second portion of thermal management fluid that is mixed with the first portion of the thermal management fluid.

In addition to one or more of the features described above, or as an alternative to any of the foregoing embodiments the directed energy weapon is operable in a firing mode and a charging mode. During operation in the firing mode, an amount of heat transferred to the thermal material exceeds an amount of heat that removable by the secondary system at the storage reservoir.

In addition to one or more of the features described above, or as an alternative to any of the foregoing embodiments during operation in the charging mode, the amount of heat that can be removed from the thermal material by the secondary system exceeds the amount of heat generated by the directed energy weapon.

In addition to one or more of the features described above, or as an alternative to any of the foregoing embodiments the thermal material is a liquid.

In addition to one or more of the features described above, or as an alternative to any of the foregoing embodiments the directed energy weapon is transformable from a firing mode to a charging mode when the temperature of the liquid reaches or exceeds a maximum allowable temperature.

In addition to one or more of the features described above, or as an alternative to any of the foregoing embodiments the directed energy weapon is transformable from a charging mode to a firing mode when the temperature of the liquid reaches a minimum allowable temperature.

In addition to one or more of the features described above, or as an alternative to any of the foregoing embodiments the secondary system is a vapor cycle.

In addition to one or more of the features described above, or as an alternative to any of the foregoing embodiments including a pump in fluid communication with the heat exchanger and the storage reservoir. The pump is operable to move the thermal management fluid within the closed loop.

According to an embodiment, a method of operating a thermal management system for a directed energy weapon includes circulating a thermal management fluid through a closed loop system including a heat exchanger, a storage reservoir containing a thermal material, and a control valve. The heat exchanger is in thermal communication with the directed energy weapon and the storage reservoir is in thermal communication with a secondary system. The method further including operating the directed energy weapon in a firing mode and adjusting the control valve to control a temperature of the thermal management fluid provided to the heat exchanger.

In addition to one or more of the features described above, or as an alternative to any of the foregoing embodiments circulating the thermal management fluid through the closed loop system further comprises providing a first portion of the thermal management fluid at an outlet of the heat exchanger to a bypass conduit to bypass the storage reservoir and the control valve, providing a second portion of the thermal management fluid at the outlet of the heat exchanger to the storage reservoir, and mixing the second portion of the thermal management fluid provided at an outlet of the storage reservoir with the first portion of the thermal management fluid from the bypass conduit.

In addition to one or more of the features described above, or as an alternative to any of the foregoing embodiments adjusting the control valve varies an amount of the second portion of the thermal management fluid mixed with the first portion of the thermal management fluid.

In addition to one or more of the features described above, or as an alternative to any of the foregoing embodiments in the firing mode circulating a thermal management fluid through the closed loop system further comprises transferring heat from the thermal management fluid to the thermal material and transferring heat from the thermal material to a secondary fluid of the secondary system.

In addition to one or more of the features described above, or as an alternative to any of the foregoing embodiments comprising operating the directed energy weapon in a charging mode. In the charging mode circulating a thermal management fluid through the closed loop system further comprises transferring heat from the thermal material to the secondary system.

In addition to one or more of the features described above, or as an alternative to any of the foregoing embodiments transforming the directed energy weapon from the firing mode to the charging mode in response to the thermal material being equal to or exceeding a maximum allowable temperature.

In addition to one or more of the features described above, or as an alternative to any of the foregoing embodiments transforming the directed energy weapon from the charging mode to the firing mode in response to the thermal material within the storage reservoir reaching a minimum allowable temperature.

### BRIEF DESCRIPTION OF THE DRAWINGS

The following descriptions should not be considered limiting in any way. With reference to the accompanying drawings, like elements are numbered alike:

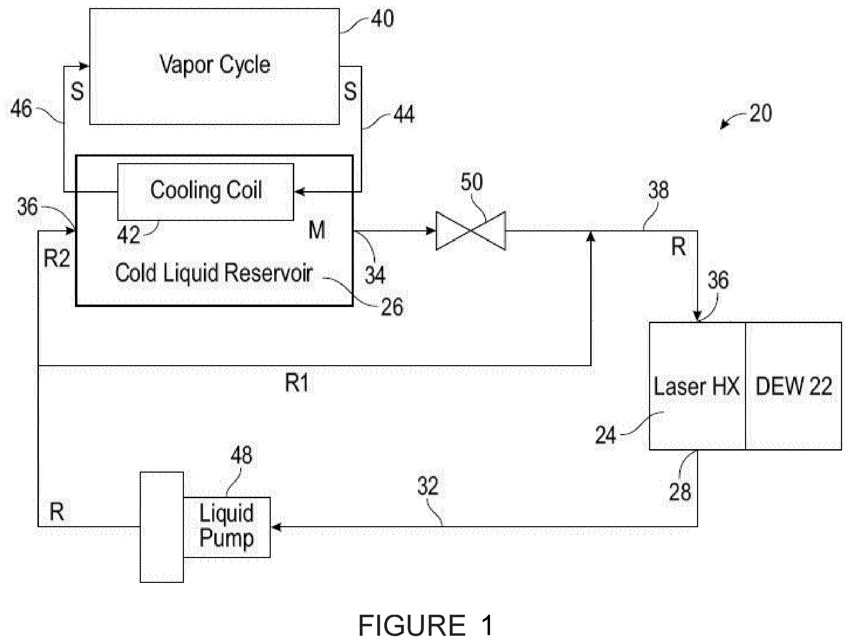

Figure 1 is a schematic diagram of a thermal management system operable to cool a directed energy weapon according to an embodiment.

### DETAILED DESCRIPTION

A detailed description of one or more embodiments of the disclosed apparatus and method are presented herein by way of exemplification and not limitation with reference to the Figures.

With reference now to the Figure, an example of a thermal management system 20 is illustrated. In the illustrated, non-limiting embodiment, the thermal management system 20 is operable to manage the heat generated by a directed energy weapon (DEW) 22, such as a laser for example. In an embodiment, the thermal management system 20 and DEW 22 are integrated into a vehicle, such as a land vehicle or an aircraft for example.

The thermal management system 20 has a closed loop configuration through which a thermal management fluid R is configured to circulate. The thermal management fluid may be ethylene glycol and water (EGW), propylene glycol and water (PGW), refrigerant, or another suitable fluid. In the illustrated, non-limiting embodiment, the thermal management system 20 includes a heat exchanger 24 and a storage reservoir 26. An outlet 28 of the heat exchanger 24 is arranged in fluid communication with an inlet 30 of the storage reservoir 26 by a conduit 32. Similarly, an outlet 34 of the storage reservoir 26 is arranged in fluid communication with an inlet 36 of the heat exchanger 24 by another conduit 38. In an embodiment, a bypass conduit 39 extends from conduit 32 at a location upstream from the inlet 30 of the storage reservoir 26 to conduit 38, to a location downstream from the outlet 34 of the storage reservoir 26. Accordingly, the thermal management fluid R within the bypass conduit 39 is configured to bypass the storage reservoir 26.

The heat exchanger 24 may be configured as an evaporator or a heat absorption heat exchanger. However, embodiments where the heat exchanger 24 is configured as a condenser or a heat rejection heat exchanger are also contemplated herein. In the illustrated, non-limiting embodiment, the heat exchanger 24 is arranged in thermal contact or communication with the directed energy weapon (DEW) 22 and is operable to cool or remove heat from the DEW 22. The heat exchanger 24 may be configured as any suitable type of heat exchanger, including, but not limited to, a phase change evaporator with a high heat flux load, such as a plate fin cold plate, or jet impingement cold plate for example.

The storage reservoir 26 is configured as a tank filled with a thermal material M having a constant mass. As shown, the thermal material M is a cold liquid. However, embodiments having another suitable thermal material M are also contemplated herein. In an embodiment, one or more tubes (not shown) extend through the interior of the tank, between the inlet 30 and outlet 34, to define a portion of the closed loop. The storage reservoir 26 may be operable in a manner similar to a condenser to reject heat from the thermal management fluid R. In the illustrated, non-limiting embodiment, the thermal material M of the storage reservoir 26 is thermally coupled to a secondary system 40 of the vehicle. As shown, the secondary system 40 is a vapor cycle. However, it should be understood that any suitable system of the vehicle may be used as the secondary system 40. In the illustrated, non-limiting embodiment, a cooling or condensing coil 42 fluidly connected to the secondary system 40 by conduits 44 and 46 is positioned within the thermal material M of the storage reservoir 26.

As shown, the thermal management system 20 may include a pump 48 operable to circulate the thermal management fluid R between the heat exchanger 24 and the storage reservoir 26. Although the pump 48 is illustrated as being arranged along conduit 32 at a position between the outlet 28 of the heat exchanger 24 and the inlet 30 of the storage reservoir 26, it should be understood that embodiments where the pump 48 is positioned elsewhere are also within the scope of the disclosure. For example, in another embodiment, the pump 48 may be located between the outlet 34 of the storage reservoir 26 and the inlet 36 of the heat exchanger 24 along conduit 38.

The thermal management system 20 may include a control valve 50 selectively operable to control the flow of thermal management fluid R from the storage reservoir 26 to heat exchanger 24. As shown, the valve 50 is arranged directly downstream from the outlet 34 of the storage reservoir 26 along conduit 38. In embodiments of the thermal management system 20 including the valve 50, the bypass conduit 39 connects to the conduit 38 at a location downstream from the valve 50.

The valve 50 is adjustable to control the temperature of the thermal management fluid R provided to the heat exchanger 24 such as to optimize the cooling performed within the heat exchanger 24. For example, when the DEW 22 is in a first or firing mode, the DEW 22 generates heat and requires cooling by the thermal management fluid R. Accordingly, during a firing mode, heat from the DEW 22 is transferred to the thermal management fluid R at the heat exchanger 24. From the outlet 28 of the heat exchanger 24, a first portion R1 of the hot and/or vapor thermal management fluid R is provided to the bypass conduit 39. Simultaneously, a second portion R2 of the hot and/or vapor thermal management fluid R is configured to pass through the storage reservoir 26. As the second portion R2 of the hot and/or vapor thermal management fluid R passes through the thermal material M, heat is transferred from the second portion R2 to the thermal material M. At the same time, the heat within the thermal material M is discharged to the fluid S circulating through the cooling coil 42. As a result, the second portion R2 of the thermal management fluid R at the outlet 34 of the storage reservoir 26 is generally a cold liquid.

The second portion R2 of the thermal management fluid output from the storage reservoir 26 passes through the control valve 50 and is mixed or rejoined with the first portion R1 of the thermal management fluid from the bypass conduit 39. By adjusting the control valve 50, the amount of thermal management fluid R provided from the storage reservoir 26 within the mixture can be varied. This ratio of the thermal management fluid R from the storage reservoir 26 to the hot thermal management fluid R from the bypass conduit 39 is controlled by the control valve 50 to form a cool liquid thermal management fluid R provided to the inlet 36 of the heat exchanger 24 to repeat the cycle.

In an embodiment, during the firing mode, the heat transferred to the thermal material M from the thermal management fluid R exceeds that heat removed from the thermal material M by the secondary fluid S within the cooling coil 42. As a result, the temperature of the thermal material M gradually increases until reaching a maximum allowable temperature at which the thermal material M is no longer capable of cooling the thermal management fluid R. In response to the thermal material M reaching or exceeding such a maximum allowable temperature, the DEW 22 may transition to a charging or recharging mode (not firing).

In the charging mode, the DEW 22 is not active and therefore does not generate heat. As a result, the thermal management fluid R need not circulate through the closed loop when the DEW 22 is in the charging mode. Accordingly, in an embodiment, the pump 48 is not operational when the DEW 22 is in the charging mode. Alternatively, or in addition, the control valve 50 may be closed when the DEW 22 is charging. However, embodiments where the pump 48 is operational and the thermal management fluid R is configured to circulate through the closed loop during a charging mode are also contemplated herein. Further, the thermal management fluid R may be configured to circulate through the storage reservoir 26 in the charging mode.

In the charging mode, the heat of the thermal material M is removed by the secondary fluid S circulating through the cooling coil 42. In an embodiment, the heat of the thermal material M is also removed by the flow of thermal management fluid R through the storage reservoir 26. In such embodiments, the heat absorbed from the thermal material M may be exhausted or discharged at another location along the closed loop, such as at the heat exchanger 24 for example. However, embodiments where the thermal management fluid R does not contribute to cooling of the thermal material M during a charging mode are within the scope of the disclosure.

Operation of the thermal management system 20 in the charging mode may continue until the thermal material M within the storage reservoir 26 reaches a minimum allowable temperature. In an embodiment, the minimum allowable temperature is about -40° However, a thermal management system 20 having a thermal material M with another minimum allowable temperature is also contemplated herein. Upon reaching the minimum allowable temperature, the DEW 22 may be configured to transition to the firing mode.

A thermal management system 20 having a storage reservoir with a fixed mass as described herein allows the thermal management system to be sized based on the average cooling load for the DEW 22, rather than the maximum cooling load. In addition, the thermal management system 20 is smaller and requires less power than existing systems.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiment disclosed as the best mode contemplated for carrying out this present disclosure, but that the present disclosure will include all embodiments falling within the scope of the claims.

## Claims

1. A thermal management system for a directed energy weapon comprising:
a heat exchanger (24) thermally coupled to the directed energy weapon (22), the heat exchanger having a heat exchanger inlet (36) and a heat exchanger outlet (28);
a storage reservoir (26) containing a thermal material, the storage reservoir having an outlet (34) and being arranged in fluid communication with the heat exchanger to form a closed loop having a thermal management fluid circulating therethrough, wherein the storage reservoir is thermally coupled to a secondary system (40); and
a control valve (50) positioned downstream from the outlet of the storage reservoir, wherein the control valve is adjustable to control a temperature of the thermal management fluid provided to the heat exchanger.

2. The thermal management system of claim 1, wherein the secondary system (40) further comprises a cooling coil (42) thermally coupled to the storage reservoir (26); and optionally, wherein the cooling coil is mounted within an interior of the storage reservoir.

3. The thermal management system of claim 1 or 2, further comprising a bypass conduit (39) extending from a position between the heat exchanger outlet (28) and an inlet (30) of the storage reservoir (26), the bypass conduit being configured to bypass the storage reservoir and the control valve (50).

4. The thermal management system of claim 3, wherein a first portion of the thermal management fluid at the heat exchanger outlet (28) is provided to the bypass conduit (39) and a second portion of the thermal management fluid at the heat exchanger outlet is provided to the storage reservoir (26), wherein the first portion of the thermal management fluid and the second portion of the thermal management fluid are mixed at a location upstream from the heat exchanger inlet (36); and optionally, wherein the control valve (50) is operable to control the temperature of the thermal management fluid provided to the heat exchanger (24) by controlling an amount of the second portion of thermal management fluid that is mixed with the first portion of the thermal management fluid.

5. The thermal management system of any preceding claim, wherein the directed energy weapon (22) is operable in a firing mode and a charging mode, and during operation in the firing mode, an amount of heat transferred to the thermal material exceeds an amount of heat that removable by the secondary system (40) at the storage reservoir (26); and optionally, wherein during operation in the charging mode, the amount of heat that can be removed from the thermal material by the secondary system exceeds the amount of heat generated by the directed energy weapon.

6. The thermal management system of any preceding claim, wherein the thermal material is a liquid.

7. The thermal management system of claim 6, wherein the directed energy weapon (22) is transformable from a firing mode to a charging mode when the temperature of the liquid reaches or exceeds a maximum allowable temperature; and/or wherein the directed energy weapon is transformable from a charging mode to a firing mode when the temperature of the liquid reaches a minimum allowable temperature.

8. The thermal management system of any preceding claim, wherein the secondary system (40) is a vapor cycle.

9. The thermal management system of any preceding claim, further comprising a pump (48) in fluid communication with the heat exchanger (24) and the storage reservoir (26), the pump being operable to move the thermal management fluid within the closed loop.

10. A method of operating a thermal management system for a directed energy weapon, the method comprising:
circulating a thermal management fluid through a closed loop system including a heat exchanger, a storage reservoir containing a thermal material, and a control valve, the heat exchanger being in thermal communication with the directed energy weapon and the storage reservoir being in thermal communication with a secondary system;
operating the directed energy weapon in a firing mode; and
adjusting the control valve to control a temperature of the thermal management fluid provided to the heat exchanger.

11. The method of claim 10, wherein circulating the thermal management fluid through the closed loop system further comprises:
providing a first portion of the thermal management fluid at an outlet of the heat exchanger to a bypass conduit to bypass the storage reservoir and the control valve; and
providing a second portion of the thermal management fluid at the outlet of the heat exchanger to the storage reservoir; and
mixing the second portion of the thermal management fluid provided at an outlet of the storage reservoir with the first portion of the thermal management fluid from the bypass conduit; and optionally, wherein adjusting the control valve varies an amount of the second portion of the thermal management fluid mixed with the first portion of the thermal management fluid.

12. The method of claim 10 or 11, wherein in the firing mode circulating a thermal management fluid through the closed loop system further comprises:
transferring heat from the thermal management fluid to the thermal material; and
transferring heat from the thermal material to a secondary fluid of the secondary system.

13. The method of claim 10 or 11 further comprising operating the directed energy weapon in a charging mode, wherein in the charging mode circulating a thermal management fluid through the closed loop system further comprises transferring heat from the thermal material to the secondary system.

14. The method of claim 13, further comprising transforming the directed energy weapon from the firing mode to the charging mode in response to the thermal material being equal to or exceeding a maximum allowable temperature.

15. The method of claim 13 or 14, further comprising transforming the directed energy weapon from the charging mode to the firing mode in response to the thermal material within the storage reservoir reaching a minimum allowable temperature.
